(19) Europäisches Patentamt
European Patent Office
Office européen des brevets

(11) **EP 3 114 704 B1**

(12) **FASCICULE DE BREVET EUROPEEN**

(45) Date de publication et mention de la délivrance du brevet:
**18.10.2023 Bulletin 2023/42**

(21) Numéro de dépôt: **15732821.2**

(22) Date de dépôt: **29.05.2015**

(51) Classification Internationale des Brevets (IPC):
**H01L 21/368** $^{(2006.01)}$ **H01L 31/18** $^{(2006.01)}$

(52) Classification Coopérative des Brevets (CPC):
**H01L 21/02568; H01L 21/02422; H01L 21/02491; H01L 21/02557; H01L 21/0256; H01L 21/02601; H01L 21/02628; H01L 31/0326; H01L 31/072; H01L 31/1864;** Y02E 10/50; Y02P 70/50

(86) Numéro de dépôt international:
**PCT/FR2015/051425**

(87) Numéro de publication internationale:
**WO 2015/185834 (10.12.2015 Gazette 2015/49)**

(54) **PROCÉDÉ DE PRÉPARATION DE COUCHE MINCE D'ABSORBEUR A BASE DE SULFURE(S) ET SÉLÉNIURES(S) DE CUIVRE, ZINC ET ÉTAIN, COUCHE MINCE RECUITE ET DISPOSITIF PHOTOVOLTAÏQUE OBTENUS**

VERFAHREN ZUR HERSTELLUNG EINER DÜNNEN ABSORBERSCHICHT AUS KUPFER-, ZINK- UND ZINNSULFID(EN) UND -SELENID(EN), GETEMPERTE DÜNNSCHICHT UND DARAUS ERHALTENE PHOTOVOLTAIKVORRICHTUNG

METHOD FOR PREPARING A THIN ABSORBER LAYER MADE FROM SULFIDE(S) AND SELENIDE(S) OF COPPER, ZINC AND TIN, ANNEALED THIN LAYER AND PHOTOVOLTAIC DEVICE OBTAINED

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.06.2014 FR 1455143**

(43) Date de publication de la demande:
**11.01.2017 Bulletin 2017/02**

(73) Titulaire: **IMRA Europe SAS**
**06560 Valbonne (FR)**

(72) Inventeurs:
• **JACOB, Alain**
**06600 Antibes (FR)**
• **CHONE, Christophe**
**06480 La Colle Sur Loup (FR)**
• **LARRAMONA, Gerardo**
**06560 Valbonne (FR)**
• **DELATOUCHE, Bruno**
**06560 Valbonne (FR)**
• **BOURDAIS, Stéphane**
**06600 Antibes (FR)**

• **DENNLER, Gilles**
**06560 Valbonne (FR)**

(74) Mandataire: **Cabinet Beau de Loménie**
**Tour Méditerranée**
**65 avenue Jules Cantini**
**13006 Marseille (FR)**

(56) Documents cités:
**WO-A1-2013/015745 WO-A1-2013/172949**

• XIANZHONG LIN ET AL: "Thin-Film Solar Cell Absorber Cu 2 ZnSnS 4 (CZTS) by Annealing of Monodisperse Kesterite Nanoparticle Precursors", PROCEEDINGS / 26TH EUROPEAN PHOTOVOLTAIC SOLAR ENERGY CONFERENCE AND EXHIBITION : THE MOST INSPIRING PLATFORM FOR THE GLOBAL PV SOLAR SECTOR ; CCH CONGRESS CENTRE AND INTERNATIONAL FAIR, HAMBURG, GERMANY, CONFERENCE 5 - 9 SEPTEMBER 2011, EXHIBITION 5, 5 septembre 2011 (2011-09-05), - 9 septembre 2011 (2011-09-09), pages 2896-2899, XP055166949, GERMANY ISBN: 978-3-936338-27-0

**Description**

La présente invention concerne un procédé de fabrication de film ou couche mince de sulfure(s) et séléniure(s) métalliques de cuivre, zinc et étain cristallisée à gros grains déposée sur un substrat. Plus particulièrement, la présente invention concerne un dispositif photovoltaïque solide comprenant une dite couche de sulfure(s) et séléniure(s) métalliques à titre de couche d'absorption.

La présente invention concerne, plus particulièrement encore :

- un procédé de recuit de couche mince d'un matériau absorbeur à base de sulfure(s) de cuivre, zinc et étain, de préférence contenant majoritairement un composé quaternaire CZTS (Cu-Zn-Sn-S), notamment avec des pourcentages variables autour du composé stœchiométrique $Cu_2ZnSnS_4$, déposée sur un substrat recouvert de molybdène (ci-après désigné par « substrat Mo »),
- une couche mince recuite ainsi obtenue d'un matériau absorbeur à base de sulfure(s) de cuivre, zinc et étain, de préférence contenant majoritairement un composé pentanaire CZTSSe (Cu-Zn-Sn-S-Se), notamment avec des pourcentages variables autour du composé stœchiométrique $Cu_2ZnSn(S_{1-a}Se_a)_4$, déposée sur un substrat Mo, et
- un dispositif photovoltaïque de type comprenant un dit substrat recouvert d'une dite couche mince d'absorption recuite.

Les dispositifs photovoltaïques du commerce sont du type silicium (Si), ou du type couche mince d'absorbeur à base de CdTe ou de $CuGa_xIn_ySe_2$ (dénommé CIGS). L'application principale de ces dispositifs photovoltaïques est comme générateur photovoltaïque domestique sur les toits des maisons. La puissance nominale typique de ces dispositifs est de l'ordre de 1-5 kilowatts (au point de puissance maximale), pour une surface de panneaux de l'ordre de 10 à 20 $m^2$ ce qui représente un rendement photovoltaïque nominale typique de l'ordre de 10-15%. Le problème principal des dispositifs à base de CdTe et CIGS est celui d'utiliser certains composés à caractère toxique (tels que ceux faits à base de Te) ou d'utiliser certains éléments peu abondants (tel que l'indium, In).

Récemment, on a proposé un nouveau dispositif photovoltaïque de type couche mince, à base de composé quaternaire de sulfure de cuivre (Cu), zinc (Zn) et étain (Sn), Cu-Zn-Sn-S, communément dénommé CZTS, en remplacement du CIGS comme alternative utilisant des éléments très abondants. Le meilleur rendement photovoltaïque rapporté est de 8,4% (Shin et al. dans Prog. Photovolt. : Res. Appl., 21, 72, 2011). Une variante de ce dispositif comprend une couche mince d'absorbeur basée sur le sulfure-séléniure de cuivre, zinc et étain (nommé CZTSSe ou CZTSe), pour lequel le meilleur rendement rapporté est de 12,6% (Wang et al. Adv. Energy Mater. 2014). Toutefois, comme décrit plus loin, ces couches minces sont obtenues par des procédés inappropriés pour une industrialisation.

La structure la plus répandue de dispositif photovoltaïque basé sur le matériau absorbeur CZTS ou CZTSSe est celle du type dit substrat et comprend différentes couches plates empilées, typiquement, comprenant au moins :

- une couche conductrice optiquement transparente dite de contact avant, par exemple de type TCO (oxyde transparent conducteur), tel que l'oxyde d'indium dopé à l'étain (ITO en anglais) ou l'oxyde de zinc dopé aluminium (AZO, en anglais), et

- une couche de composé isolant et transparent, par exemple une couche de ZnO ou $ZnMg_xO_{1-x}$, et

- une couche tampon de semi-conducteur de type n, par exemple de CdS ou $In_2S_3$ ou Zn(S,O,OH), et

- une couche dite couche d'absorption de type p, et

- une couche de matériau conducteur dite de contact arrière, par exemple une couche de métal molybdène (Mo), or (Au), graphite (C), Nickel (Ni) ou encore d'aluminium (Al), argent (Ag) ou indium (In).

Dans un dispositif photovoltaïque solide dit de type substrat, les couches ci-dessus sont complétées par :

- une grille métallique appliquée contre ladite couche de contact avant, constituant ainsi la face avant (côté soleil) du dispositif, et

- une couche de verre ou acier appliquée contre ladite couche de contact arrière.

Des dispositifs photovoltaïques solides à structure de type substrat sont bien connus de l'Homme de l'art. Ils sont par exemple décrits dans le livre « Thin film solar cells ; fabrication, characterization and applications », édité par Jef Poortmans et Vladimir Arkhipov, Wiley 2007.

La différence majeure entre les différents dispositifs photovoltaïques CZTS ou CZTSSe est la procédure de fabrication. Elle n'a pas seulement une incidence sur le coût de fabrication, mais aussi elle détermine les caractéristiques morphologiques, optiques et surtout électroniques de la couche, qui ont une incidence fondamentale dans la performance photovoltaïque du dispositif.

Dans l'état de l'art, on ne peut pas prédire quelle sera l'incidence d'une méthode de fabrication particulière sur les propriétés de la couche.

Des couches minces de CZTS ou CZTSSe ont été déposées par différents méthodes, utilisant autant des techniques de dépôt sous vide que des techniques de dépôt à pression atmosphérique, notamment en utilisant des solutions de précurseurs ou des suspensions des particules dans des liquides. Dans la plupart de techniques on dépose une ou plusieurs couches en utilisant des précurseurs comme des métaux (Cu, Sn, Zn ou des alliages), des mélanges de sulfures et/ou séléniures d'un seul métal, des sels des métaux dissoutes (avec ou sans précurseur de soufre), ou ses combinaisons.

Dans WO 2013/172949 et WO 2013/015745, on prépare des couches recuites de particules de composés CZTS/Se à partir de dispersion de mélange de nanoparticules binaires M-S ou ternaires M-M'-S. Ces procédés ne permettent pas d'obtenir des particules de CZTS/Se de taille supérieure à 300nm.

Dans d'autres techniques on part du matériau CZTS ou CZTSSe déjà formé, comme des dispersions colloïdales, encres ou pâtes à base des particules (de taille micrométrique ou nanométrique) de CZTS ou CZTSSe (pour des dépôts liquides) ou de la poudre CZTS ou CZTSSe compactée en pastille frittée (pour des dépôts sous vide). Ces techniques pourraient permettre un meilleur contrôle de la stoechiométrie, faite lors de l'étape de fabrication des particules CZTS ou CZTSSe, et aussi elles pourraient avoir un moindre risque de présence de phases secondaires, puisque le matériau de départ est le même que celui de la fin.

Les procédés de dépôt sous vide ont le désavantage du coût de fabrication. Parmi les procédés de dépôt à pression atmosphérique, les techniques de la tournette (« spin coat », en anglais) ou l'électro-dépôt des solutions liquides de précurseurs présentent des désavantages tels qu'un temps long de dépôt, l'impossibilité d'appliquer une méthode de dépôt industrielle en continu (« roll-to-roll » en anglais), ou la difficulté de contrôler la stoechiométrie du composé absorbeur. Les techniques de pulvérisation (« spray » en anglais) ou de coulage en bande (« tape casting » en anglais) des solutions de précurseurs ou des suspensions (encres) de particules du matériau CZTS ou CZTSSe permettent un dépôt en continu, ce qui est préférable industriellement pour réduire le temps de fabrication et augmenter la reproductibilité.

Le meilleur rendement de 12,6% cité ci-dessus avec un dispositif à base de CZTSSe comme absorbeur (Wang et al. Adv. Energy Mater. 2014) utilise une solution de précurseurs de sels métalliques dans le solvant hydrazine, solvant qui est très toxique, et le dépôt par la technique désavantageuse dite de « spin coat ».

Dans l'article de Carter et al. dans Solar Energy Mater. Solar Cells 123 (2014) 189, un dispositif basé sur le CZTSSe utilise une suspension ou encre des nano-cristaux de CZTS dans le solvant hexanethiol, et un dépôt par « tape casting », suivi d'un recuit avec des vapeurs de Se. Le rendement du dispositif était de 8,4%. Le désavantage de ce procédé est le temps long de synthèse de nano-cristaux de CZTS.

Dans l'article de Cao et al. dans J. Am. Chem. Soc. 134 (2012) 15644, un dispositif basé sur le CZTSSe utilise une suspension ou encre des nano-cristaux de CZTS dans le solvant hexanethiol, et un dépôt par « tape casting », suivi d'un recuit avec des vapeurs de Se. Le rendement du dispositif était de 8,5%. Le désavantage de ce procédé est le temps long de synthèse de nano-cristaux de CZTS et l'usage d'un solvant toxique (l'oxyde de trioctylphosphine, TOPO) lors de cette synthèse.

Dans l'article de Zhang et al. dans Appl. Phys. Express 6 (2013) 072302, un dispositif basé sur le CZTSSe utilise une suspension de nanoparticules de CZTSSe dans le mélange de solvants pyridine-méthanol, et un dépôt par pulvérisation, suivi d'un recuit avec des vapeurs de Se. Le rendement du dispositif a été seulement de 5,4%.

Dans d'autres publications des dispositifs CZTS ou CZTSSe faits avec des suspensions de nanoparticules ou microparticules de CZTS déposées par pulvérisation ou par « tape casting », les dispositifs fabriqués avec ces couches montrent une faible performance photovoltaïque. En outre, dans plusieurs d'entre eux, les couches sont faits petits grains (de moins de 700 nm) et/ou elles sont poreuses, ce qui est une limitation pour atteindre des performances élevées.

Dans l'article de Larramona et al. dans RSC Advances 4 (2014) 14655, on a décrit une couche CZTS déposée avec une méthode de pulvérisation d'une suspension colloïdale de nanoparticules de CZTS (sans sélénium), recuite en deux étapes dans deux atmosphères différentes, donnant lieu à un rendement photovoltaïque de 5%. La méthode de fabrication de la suspension colloïdale de nanoparticules de CZTS et la méthode du dépôt sont très rapides et font usage de solvants non toxiques, notamment, des solutions hydro-alcooliques.

On connaît des dispositifs basés sur le CZTS avec remplacement partiel du soufre (S) par du sélénium (Se) dans le composé CZTS, donnant lieu au composé CZTSSe, qui garde la même structure cristalline avec une légère augmentation de la maille. Suite à ce remplacement, les propriétés d'absorption de la lumière, et le photo-courant et la tension à circuit ouvert théoriques des dispositifs photovoltaïques faits avec ce composé, peuvent être modifiées sans que l'on puisse contrôler et expliquer ces modifications, et notamment prédire quel est le taux de remplacement de Se qui donnerait la meilleure performance du dispositif photovoltaïque.

Deux approches sont connues pour fabriquer des couches CZTSSe contenant du Se. L'une consiste à partir de précurseurs qui contiennent les cinq éléments, dont le Se. L'autre consiste à partir de précurseurs sans Se et soumettre la couche déposée à une seule étape de recuit en présence de vapeurs de Se à une température élevée, qui vont réagir et incorporer le Se lors de ce recuit.

L'étape de recuit de la couche peut aussi servir à faire réagir les précurseurs de sels métalliques qui ne sont pas encore sous la forme du composé CZTS ou CZTSSe, à densifier la couche, et à faire croître les grains de CZTS. L'étape de recuit sous atmosphère de Se connue de l'état de l'art consiste typiquement en une seule étape de recuit à une température de 500-580°C, en présence de Se solide (qui dégage des vapeurs de Se une fois chaud).

Il y a eu aussi quelques publications résumées ci-après qui ont proposé un recuit à deux étapes, la première étant sans Se, mais la taille des grains était bien inférieure au micron et le rendement photovoltaïque était au mieux de 7,1% pour une d'entre elles.

Dans l'article de Ki et al., Adv. dans Energy Mater. 1 (2011) 732, la couche a été déposée avec une solution de précurseurs de sels métalliques (et non pas des particules du composé quaternaire CZTS ou du composé pentanaire CZTSSe) en utilisant la technique de « spin coat ». La couche a été d'abord recuite à 580°C dans le $N_2$, et après dans le Se à 580°C ; cependant, la taille de grain n'a pas atteint 700nm et le rendement photovoltaïque a été de 4%, avec des photo-courants de moins de 25 mA/cm$^2$.

Dans l'article de Woo et al. dans Scientific Reports, 3 (2013) 3069, la couche a été déposé avec un encre à base d'un mélange de particules $Cu_2S$-Zn-Sn-S commerciales de grosses tailles (typiquement supérieures à 1 micron, voire 10 microns), préalablement broyées pendant 24 heures, en utilisant là encore la technique de « spin coat ». La couche a été d'abord recuite à 530°C dans une atmosphère avec $H_2S$, afin de sulfuriser les précurseurs, et après dans des vapeurs de Se dans un gaz porteur neutre à 500°C. Bien qu'ils aient atteint un rendement photovoltaïque de 7,1% (avec des photo-courants jusqu'à 26mA/cm$^2$), la taille de grains était inférieure à 500nm, ce qui est une limitation pour augmenter le rendement.

Dans l'article de Li et al., J. Sol-Gel Sci. Technol. 69 (2014) 260, la couche a été déposée avec une solution de précurseurs de sels métalliques (et non pas des particules du composé quaternaire CZTS ou du composé pentanaire CZTSSe) en utilisant la technique de « spin coat ». La couche a été d'abord recuite à 500°C dans le $N_2$, et après dans des vapeurs de Se à 580°C; cependant, la taille de grain n'a pas atteint 500nm et elle était trop poreuse; aucun dispositif photovoltaïque n'a été fabriqué.

Les couches de CZTSSe obtenues dans ces procédés ci-dessus, ne présentaient pas des propriétés satisfaisantes en termes de compacité, porosité, ou homogénéité, telles que définies ci-après ; ces couches n'étaient pas compactes, et étaient de trop grande porosité, inhomogènes, avec des grains de moins de 700nm, et/ou avec présence de défauts de recouvrement du fait du grand nombre de trous isolés dans la couche.

Un problème lors du recuit de couches déposées avec des suspensions de nanoparticules est donc celui d'arriver à des couches compactes, sans porosité, et avec des tailles moyennes de grains de l'ordre au moins du 1 micron et avec une limitation des défauts de recouvrement par trous isolés dans la couche de taille supérieure à 10 microns.

Un autre problème lors de la fabrication des couches d'absorbeur CZTSSe est la présence de défauts dans les grains de CZTSSe eux-mêmes, qui peuvent favoriser la recombinaison de porteurs de charge, et donc diminuer la performance photovoltaïque. Dans l'état de l'art on ne sait pas bien contrôler la concentration pour diminuer ce type de défauts.

Un autre problème important lors de la fabrication des couches CZTSSe tel que décrit ci-dessus est celui de la présence indésirable des phases cristallines secondaires autres que $Zn(S_xSe_{1-x})$, avec x de 0 à 1, en particulier des phases binaires et ternaires de sulfures et/ou séléniures d'un seul ou respectivement deux des métaux Cu, Zn et Sn. Dans les cas des dépôts à partir de dispersions colloïdales comprenant des particules de CZTS déjà formées, ces phases secondaires peuvent apparaître à cause de réactions de décomposition du matériau lui-même ou par interaction avec le substrat lors de l'étape de recuit à haute température. Certaines de ces phases secondaires sont suspectées de dégrader la performance photovoltaïque du fait qu'elles favoriseraient la recombinaison de porteurs de charge. Une de ces phases secondaires est le $Sn(S_xSe_{1-x})$ avec x de 0 à 1.

Un autre problème lors de la fabrication de couches CZTSSe est celui d'éviter de créer un nombre élevé de défauts électroniques qui dégradent la performance lorsqu'on utilise ces couches pour fabriquer des dispositifs photovoltaïques.

Le but de la présente invention est de fournir un procédé de fabrication des couches minces d'absorbeur pour dispositif photovoltaïque amélioré qui apportent une solution aux problèmes mentionnés ci-dessus.

Un but de la présente invention est de fournir des couches minces d'absorbeur pour dispositif photovoltaïque fabriquée de façon rapide, déposée avec une méthode industriellement compatible avec le dépôt sur de grandes surfaces telle que la pulvérisation, et suivie d'une méthode de recuit, produisant ainsi des couches qui sont compactes, avec un taux élevé de recouvrement du substrat, avec une très faible porosité, et avec des gros grains cristallisés et une absence de trous isolés de taille supérieure à 10 microns.

Un autre but de la présente invention est de fournir des dispositifs photovoltaïques faits avec ces couches minces d'absorbeur pour dispositif photovoltaïque qui présentent des performances photovoltaïques améliorées, notamment de rendements photovoltaïques supérieurs à 7%, de préférence supérieurs à 8%, et des photo-courants supérieurs à 25 mA/cm$^2$, de préférence supérieurs à 30mA/cm$^2$.

On entend ici par :

- «dispersion de particules sous forme liquide», un colloïde contenant une dispersion homogène de nanoparticules dont les dimensions vont de 2 à 500 nm, et pouvant contenir des additifs pour assurer la dispersion et faciliter le dépôt sous forme d'encre, tels que des surfactants, des agents liants, des agents de blocage de surface («capping agents» en anglais), etc. ; la stabilité d'une telle dispersion homogène est due à la lenteur de la séparation des 2 phases solide et respectivement liquide ;

- « nanoparticules primaires », des nanoparticules telles qu'obtenues avant leur agrégation ou agglomération ultérieure éventuelle sous forme d'agrégat de plus grande taille de plusieurs nanoparticules primaires entre elles ;

- « couche dense » ou « couche compacte », une couche recuite constituée de gros grains accolés en contact direct entre eux, au moins sur une partie de leur surface externe, et dont le taux de recouvrement de la surface du substrat par le dépôt est de plus de 98%, et dont la couche présente une porosité inférieure à 10%, idéalement ne présentant pas de porosité apparente ;

- « porosité », le pourcentage de volume vide entre lesdits gros grains accolés au sein de la couche

- « gros grains », des particules de taille moyenne supérieure ou égale à 700nm, plus particulièrement, une taille moyenne de l'ordre de 1 $\mu$m ou supérieur, résultant de la croissance desdites nanoparticules lors de l'étape de traitement thermique;

- « une couche avec peu ou pas de phases secondaires cristallines », une couche dont l'aire des pics principaux du DRX correspondant aux dites phases secondaires cristallines est inférieure à 1/50 à l'aire du pic principal de la phase cristalline pentanaire CZTSSe par mesure quantitative par DRX (Diffraction par Rayon X) ; et

- « composition homogène », une couche ne comportant pas de zone dont la composition en composition atomique élémentaire tel que constatée par cartographie EDX soit nettement différenciée par rapport à la composition moyenne de la couche.

Pour ce faire, la présente invention fournit une méthode qui consiste à préparer une couche mince de CZTSSe par un procédé de dépôt à partir d'une dispersion hydro-alcoolique colloïdale de nanoparticules de composé quaternaire CZTS (sans Se) de petites tailles, dans laquelle on a éliminé les agglomérats de nanoparticules primaires de taille d'agglomérat supérieure à 10 $\mu$m, de préférence de taille supérieure à 5 $\mu$m, déposée à pression atmosphérique, par exemple par pulvérisation ou par impression, la couche ainsi déposée étant ensuite recuite avec deux étapes de recuit dans des atmosphères différentes : une première étape de recuit dans une atmosphère inerte (tel que l'azote, N$_2$, ou l'argon, Ar), et une deuxième étape de recuit dans une atmosphère d'un gaz porteur inerte contenant des vapeurs de Se et pouvant aussi contenir de vapeurs d'un composé de Sn, de préférence du SnS.

Ce procédé de recuit peut être réalisé avec les deux étapes de recuit bien différenciées, avec un cycle de refroidissement entre les deux et éventuellement un changement d'appareil de recuit, ou bien, dans un seul appareil de recuit, avec changement d'atmosphère pendant que la couche est encore dans l'intervalle de température élevée.

Plus précisément, la présente invention fournit un procédé selon la revendication 1. C'est un procédé de fabrication d'une couche mince de matériau absorbeur composé essentiellement de sulfure(s) et séléniure(s) de Cu, Zn et Sn, avec des pourcentages atomiques des trois métaux Cu, Zn et Sn pouvant varier dans l'intervalle de x=40 à 60% pour le Cu et y= 15 à 35% pour le Zn et z= 15 à 35% Sn, avec x+y+z=100%, avec un pourcentage atomique de Se en remplacement du S pouvant varier dans l'intervalle de 5% à 100%, de préférence de 30 à 90%, sous forme de composé pentanaire Cu-Zn-Sn-S-Se, ci-après désigné par un composé CZTSSe, à gros grains cristallins de tailles moyennes d'au moins 700nm, ladite couche mince d'absorbeur étant déposée sur un (ou des) matériau(x) en couche(s) formant un substrat, dans lequel on réalise les étapes successives suivantes :

1) on dépose une couche à l'aide d'une dispersion de particules, sous forme de liquide, lesdites particules étant des nanoparticules de sulfure(s) de Cu, Zn et Sn, contenant majoritairement des nanoparticules de composés quaternaires Cu-Zn-Sn-S (CZTS), sur une couche de molybdène (Mo) d'un dit substrat recouvert d'une couche de molybdène (Mo), et

2) on réalise un traitement thermique de recuit de ladite couche déposée sur ledit substrat, à une température maximale d'au moins 450°C, pour obtenir une cristallisation et une croissance des nanoparticules,

caractérisé en ce que :

à l'étape 1), on dépose une couche à l'aide d'une dispersion hydro-alcoolique colloïdale de particules, lesdites particules comprenant des nanoparticules primaires majoritairement de composés quaternaires de sulfure(s) de Cu, Zn et Sn de tailles inférieures à 100 nm, dans laquelle on a éliminé les agglomérats de nanoparticules primaires de taille d'agglomérat supérieure à 5 $\mu$m, déposée à pression atmosphérique, sous forme de liquide par pulvérisation ou par impression,

- à l'étape 2), ledit traitement thermique comprend deux étapes de recuit dans des atmosphères différentes suivantes successives, pour obtenir des gros grains cristallins de tailles moyennes d'au moins 700nm, sur une épaisseur de 1 à 5 $\mu$m, de préférence de 1 à 3 $\mu$m, à savoir:
- une première étape de recuit dans une atmosphère de gaz neutre tel que l'azote ($N_2$) ou l'argon (Ar), et
- une deuxième étape de recuit dans une atmosphère de gaz neutre tel que l'azote ($N_2$) ou l'argon (Ar) contenant des vapeurs de Se, de préférence contenant en outre des vapeurs d'un composé de Sn comme spécifié ci-après.

La présente invention fournit des couches minces d'absorbeur de CZTSSe compactes, à grand taux de recouvrement, et avec des gros grains cristallisés, avantageuses par rapport à des couches fabriquées utilisant d'autres méthodes qui utilisent des solutions ou des suspensions et d'autres procédés de recuit où la taille de grains n'arrive pas à 700nm, sans ou avec peu de phases secondaires, et dont les rendements photovoltaïques sont supérieurs à 7%, voire supérieures à 8%, et des photo-courants supérieurs à 25mA/cm$^2$, voire supérieurs à 30mA/cm$^2$.

En outre, ces couches minces et compactes d'absorbeur de CZTSSe sont préparées par un procédé rapide, n'utilisant pas des solvants toxiques, et industriellement compatible pour un dépôt sur de grandes surfaces.

Le composé CZTSSe est constitué au moins majoritairement, de préférence essentiellement, de sulfure(s)-séléniure(s) de Cu, Zn et Sn sous forme de composé pentanaire Cu-Zn-Sn-S-Se, avec des pourcentages atomiques indiqués ci-dessus, le composé stoechiométrique dont les pourcentages atomiques Cu:Zn:Sn sont de 50:25:25 correspondant au composé $Cu_2SnZn(S_{1-p}Se_p)_4$ (p variant de 0,05 à 1) n'étant pas nécessairement la meilleure composition du point de vue qualité photovoltaïque.

A l'étape 1), on entend par « nanoparticules de sulfure(s) de Cu, Zn et Sn, contenant majoritairement des nanoparticules de composés quaternaires Cu-Zn-Sn-S (CZTS), un taux de composés quaternaires d'au moins 70%, de préférence au moins 90%, le reste étant constitué de nanoparticules binaires M-S ou ternaires M-M'-S, M et M' étant Cu, Zn ou Sn.

Ledit « matériau absorbeur de sulfure(s)-séléniure(s) de Cu, Zn et Sn », est constitué essentiellement de Cu, Zn et Sn et S et Se, le composé pouvant contenir un petit pourcentage de pas plus de 4% (pourcentages atomiques) d'impuretés provenant d'autres éléments tels que Na et Cl ou autres provenant de l'utilisation de précurseurs de dites particules de sulfures métalliques telles que particules de CZTS, dans le procédé de préparation de la suspension et/ou provenant du substrat et/ou l'enceinte du dépôt ou du recuit dans laquelle la fabrication a été réalisée.

La couche de CZTSSe obtenue est une « couche dense » ou «couche compacte», telle que définie ci-dessus, et présente peu de trous de plus de 10$\mu$m de taille, typiquement moins de 10 trous par cm$^2$.

Lesdits « gros grains » sont des particules de taille moyenne supérieure ou égale à 700 nm, plus particulièrement, une taille moyenne de l'ordre de 1 $\mu$m ou supérieur, résultant de la croissance desdites nanoparticules du colloïde précurseur lors de l'étape de traitement thermique.

La couche a « peu ou pas de phases secondaires cristallines » puisque l'aire des pics principaux du DRX correspondant aux dites phases secondaires cristallines est inférieure à 1/50 à l'aire du pic principal de la phase cristalline pentanaire CZTSSe par mesure quantitative par DRX (Diffraction par Rayon X). Exception est faite de la phase secondaire $Zn(S_xSe_{1-x})$, dont la présence est plus tolérable que les autres phases secondaires.

La couche a une « composition homogène » tel que constatée par cartographie EDX qui ne montre pas des zones nettement différenciées par rapport à la composition moyenne de la couche, sauf éventuellement quelques zones plus riches en Zn, du fait de la présence de la phase secondaire $Zn(S_xSe_{1-x})$.

La méthode selon cette invention s'est avérée efficace pour arriver à une morphologie de la couche appropriée (gros grains, recouvrement élevé), et à une performance améliorée du dispositif photovoltaïque correspondant.

Plus particulièrement, à l'étape 2), on réalise une deuxième étape de recuit dans une atmosphère de gaz neutre tel que l'azote ($N_2$) ou l'argon (Ar) contenant des vapeurs de Se, et contenant des vapeurs d'un composé de Sn, de préférence le SnS. On entend ici par « composé de Sn » un composé pluri-atomique contenant du Sn tel que le Sn métal, le SnS, le $SnS_2$, le SnSe, le $SnSe_2$, et autres.

La mise en oeuvre de ces composés de Sn, qui se vaporisent très peu, ne joue pas sensiblement sur le taux de remplacement de S par Se dans le composé CZTSSe, mais influe favorablement sur les propriétés photovoltaïques.

Ces composés de Sn se vaporisent très peu car leur pression partielle de vapeur saturante est inférieure à 0,1 Pa (1 microbar). La présence d'un composé de Sn en plus de Se peut limiter le risque d'une petite perte de Sn de la couche et le risque de l'accroissement des défauts électroniques liés à cette perte.

Avantageusement, dans la deuxième étape de recuit, on vaporise l'élément Se à partir dudit élément solide en excès, et le cas échéant le composé de Sn, de préférence SnS, à partir de dit composé solide en excès.

Plus particulièrement, dans la deuxième étape de recuit, on vaporise l'élément Se de manière à atteindre une pression partielle de vapeur de Se de 100 à $3 \cdot 10^4$ Pa (de 0,001 à 0,3 bar), de préférence de $1 \cdot 10^3$ à $5 \cdot 10^3$ Pa (de 0,01 à 0,05 bar), et le cas échéant on vaporise le composé de Sn de manière à atteindre une pression partielle entre 10% et 100% de sa pression de vapeur saturante à la température de recuit pour l'intervalle de températures de 450 à 600°C, de préférence entre $10^{-6}$ et 0,1 Pa pour le composé SnS.

La pression partielle de vapeur de Se conditionne le taux de remplacement de S par le dit élément Se, lequel taux croit avec la valeur de dite pression partielle.

La pression partielle de vapeur de Se de 100 à $3 \cdot 10^4$ Pa (de 0,001 à 0,3 bar) correspond à un taux de remplacement du S par Se dans le CZTS de 5% à 100%.

La pression partielle de vapeur de Se de $1 \cdot 10^3$ à $5 \cdot 10^3$ Pa (de 0,01 à 0,05 bar) correspond à un taux préféré de remplacement du S par Se dans le CZTS de 30% à 90%.

Plus particulièrement, on met en oeuvre un refroidissement entre les deux étapes recuits et/ou un changement d'appareil de recuit, ou bien, dans un seul appareil de recuit, avec changement d'atmosphère pendant que la couche est encore dans l'intervalle de température élevée.

Plus particulièrement, la température maximale pour les deux première et deuxième étapes de recuit est de 450 à 600°C, de préférence de 500 à 590°C, et la durée du traitement à ladite température maximale est de 10 à 120 minutes, et notamment la durée de la montée en température jusqu'à la température maximale est de préférence de 15 à 60 minutes.

Plus particulièrement encore, on réalise une étape intercalaire de refroidissement, de préférence jusqu'à température ambiante, entre les première et deuxième étapes de recuit, et de préférence la durée de la montée en température jusqu'à la température maximale lors desdites première et deuxième étapes de recuit étant de 30 à 60 minutes.

De préférence, ladite dispersion de particules est une dispersion colloïdale hydro-alcoolique liquide de nanoparticules primaires de tailles de 2 à 50 nm, de préférence inférieures à 30 nm, notamment de 3 à 20 nm, dans laquelle on a éliminé les agglomérats de nanoparticules primaires de taille d'agglomérat supérieure à 10 μm, de préférence de taille supérieure à 5 μm, et pouvant contenir un pourcentage atomique d'un élément alcalin ou alcalino-térreux, de préférence le Na, inférieur à 4% en pourcentage atomique.

La diminution des agrégats de grosses tailles par l'élimination des agrégats ou agglomérats de nanoparticules primaires de taille d'agglomérat supérieure à 5 μm, se traduit par une meilleure compacité de la couche avec une diminution des trous de tailles supérieure à 10 μm et un meilleur rendement photovoltaïque. Cette élimination peut se faire par retraits des agglomérats par séparation en fonction de la taille, notamment par filtration ou centrifugation à basse vitesse (inférieure à 700g), ou par casse des agglomérats par lyse mécanique, notamment par agitation vigoureuse par broyage à billes, ou par lyse physique, notamment par traitement physique par ultrasons. Dans le cas desdits agglomérats, leur taille est en rapport avec leurs poids c'est pourquoi, on peut mettre en oeuvre une séparation par centrifugation.

Plus particulièrement, ladite dispersion colloïdale consiste en desdites nanoparticules en dispersion dans un solvant de dispersion consistant dans une dispersion aqueuse, alcoolique ou hydro-alcoolique de nanoparticules, ledit alcool de ladite solution présentant une température d'ébullition inférieure à celle de l'eau, de préférence ledit solvant de dispersion consistant de préférence en un mélange eau/éthanol.

L'obtention de nanoparticules primaires de plus petites tailles dispersées dans les solvants aqueux et/ou alcooliques de la présente invention est avantageux pour obtenir non seulement, dans un premier temps un colloïde stable sans ajout de ligand mais aussi dans un second temps un film homogène à gros grains cristallisés sans impuretés résiduelles de ligands organiques dans le procédé de fabrication décrit ci-après.

De préférence encore, ladite dispersion colloïdale est préparée en réalisant les étapes successives suivantes dans lesquelles :

a) on réalise une première solution aqueuse, alcoolique ou hydro-alcoolique de précurseurs de sulfures consistant dans un (ou des) sel(s) métallique(s) de sulfure(s), autres que des sels de cuivre, zinc et étain, de préférence dans de l'eau, ledit sel métallique de sulfure(s) étant de préférence un sel alcalin ou alcalino-terreux, de préférence encore un sel de sodium ou potassium, et

b) on réalise une deuxième solution de précurseurs de cuivre, zinc et étain, autres que des sulfures de cuivre, zinc et étain, en solution dans un solvant comprenant de l'acétonitrile pur ou en mélange avec de l'eau et/ou un alcool, de préférence autre que le méthanol, ledit sel de cuivre, zinc et étain étant de préférence un halogénure, de préférence encore un chlorure, et

c) on mélange à pression atmosphérique et température ambiante les 2 dites première et deuxième solutions de précurseurs jusqu'à obtenir une dispersion colloïdale brute, et

d) on sépare la partie solide de ladite dispersion colloïdale de l'étape c), de préférence par centrifugation à au moins 8000g, pour obtenir un précipité du solide après retrait du surnageant liquide, et

e) on rince le précipité solide obtenu à l'étape d) en y versant un solvant aqueux, d'acétonitrile, alcoolique ou hydro-alcoolique pour réformer une dispersion colloïdale, l'alcool de ladite dispersion colloïdale alcoolique ou hydro-alcoolique étant de préférence de l'éthanol, et

f) on sépare à nouveau le précipité solide de ladite dispersion colloïdale de l'étape e), de préférence par centrifugation à au moins 8000g, pour obtenir, après retrait du surnageant liquide, un précipité rincé sous forme de pâte humide, et

g) de préférence, on réitère une ou plusieurs fois, les étapes e) et f) de rinçage du colloïde, par centrifugation puis une ré-dispersion dans un solvant aqueux, alcoolique ou hydro-alcoolique et

h) on élimine les éventuels agglomérats de nanoparticules primaires de tailles d'agglomérat supérieure à 5 $\mu$m, par technique de séparation en fonction de la taille, par filtration ou de préférence centrifugation à basse vitesse, de moins de 700g, ou par lyse mécanique, de préférence par broyage, ou par lyse physique, de préférence par traitement aux ultra-sons.

Selon la présente invention, dans le procédé de préparation de la dispersion colloïdale, on réalise donc la préparation préalable à température ambiante ou nécessitant un chauffage réduit de deux solutions séparées de précurseurs à base de sels de Cu, Zn et Sn et respectivement de sulfure avec des solvants différents, sans ajout de ligand, notamment aux étapes a) et b), et leur mélange à température réduite notamment à température ambiante et pression atmosphérique tel que défini aux étapes a) à c).

On entend ici par « ligand », une molécule organique apte à se lier et/ou à complexer un ou plusieurs des métaux Cu, Zn ou Sn, notamment une molécule organique substituée par au moins un groupe choisi parmi les groupes amine (-NH$_2$), thiol (-SH), amide ou thioamide, notamment -CONH$_2$ ou -CSNH$_2$, et/ou des groupes d'acide organique tels que le groupe acide carboxylique -COOH ou un groupe acide phosphorique, notamment -PO$_3$H$_2$.

Une dispersion colloïdale stable à température ambiante obtenue sans ajout de ligand comprend moins d'impuretés résiduelles, ce qui contribue à améliorer la qualité d'un film obtenu après dépôt de la dispersion colloïdale et recuit de la couche résultante comme décrit ci-après. En particulier, ceci contribue à obtenir un film continu cristallisé à gros grains et plus homogène avec de meilleures performances photovoltaïques.

De préférence, à l'étape g) on met en oeuvre un solvant de dispersion consistant dans une dispersion aqueuse, alcoolique ou hydro-alcoolique, l'alcool de ladite solution alcoolique ou hydro-alcoolique étant un alcool non toxique présentant une température d'ébullition inférieure à la température d'ébullition de l'eau, de préférence de l'éthanol ou propanol, de préférence encore consistant en un mélange eau/éthanol.

Ces solvants de dispersion ont été sélectionnés pour leur propriété de dispersion des nanoparticules (concentration, stabilité du colloïde, viscosité, non toxicité), permettant de former un colloïde liquide, homogène et stable avec des nanoparticules de petites tailles, qui ne précipitent pas naturellement à température ambiante avant au moins 24 heures, et peuvent être déposées par pulvérisation (viscosité, pression de vapeur et température d'évaporation) dans des conditions optimales afin d'obtenir un film continu, homogène et sans impuretés tel que décrit ci-après.

Un alcool présentant un point d'ébullition inférieur à celui de l'eau est avantageux car dans un procédé de fabrication de film obtenu par dépôt, par pulvérisation et recuit de la dispersion colloïdale sur un substrat tel que décrit ci-après, lors du contact de la solution colloïdale sur la plaque chaude du substrat, il y a évaporation des solvants et, il apparaît préférable que l'alcool s'évapore avant l'eau pour écarter les risques de contamination résiduel en carbone provenant dudit alcool au sein dudit film.

L'éthanol et le propanol sont préférés du fait de leur miscibilité totale dans l'eau, outre leur température d'ébullition inférieure à celle de l'eau (et pression de vapeur supérieure à celle de l'eau).

On définit la température ambiante utilisée pour la préparation des solutions ainsi que lors du mélange des étapes a) à c) comme étant une température comprise entre 0°C et 50°C, de préférence de 20 à 40°C.

Ce procédé de préparation de dispersion colloïdale est donc particulièrement avantageux en ce que :

- il est réalisé à température réduite notamment à température ambiante et pression atmosphérique,

- il est quasi instantané et fournit un colloïde homogène et stable, et

- il permet la mise en oeuvre de solvant aqueux en l'absence de solvant toxique et/ou de ligand organique à liaison covalente, et

- l'acétonitrile n'est pas un solvant dangereux ou toxique et permet de protéger les atomes des cations métalliques contre l'oxydation ou contre l'hydrolyse des précurseurs et/ou des particules formées, sans être engagé dans une liaison covalente contrairement à un ligand.

La rapidité de la réaction à l'étape c), typiquement réalisée dans un laps de temps inférieur à une minute, même inférieur à 5 secondes, est la conséquence de l'absence de ligand complexant et liant dudit métal et de la présence concomitante de précurseur sulfure.

Cette rapidité de réaction des précurseurs à l'étape c), contribue à obtenir des nanoparticules de plus petites tailles, les nanoparticules n'ayant pas le temps de grandir les unes au dépend des autres.

D'autre part, les concentrations élevées et les petites tailles des nanoparticules confèrent une plus grande stabilité du colloïde de nanoparticules obtenues à l'étape c), celles-ci restant stable au moins 24h voire deux jours à température ambiante.

La dispersion colloïdale obtenue permet en outre d'obtenir un film de sulfure(s) de Cu, Zn et Sn cristallin(s) à gros grains conformément au but de la présente invention après dépôt et recuit d'une couche de nanoparticules de sulfure(s) de Cu, Zn et Sn sur un substrat.

Ce procédé de préparation de dispersion colloïdale est particulièrement avantageux en ce que :

- il est réalisé à température ambiante et pression atmosphérique,

- il est quasi instantané et fournit un colloïde stable,

- il permet la mise en oeuvre de solvant aqueux en l'absence de solvant toxique et/ou de ligand organique à liaison covalente,

- l'acétonitrile n'est pas un solvant dangereux ou toxique et permet de protéger les atomes des cations métalliques contre l'oxydation ou contre l'hydrolyse des précurseurs et/ou des particules formées, sans être engagé dans une liaison covalente contrairement à un ligand, et

- les sous-produits de réaction sont plus facilement dissous et éliminés à l'aide d'un nombre d'étapes de rinçage moindre avec des solvants de rinçage aqueux, alcoolique ou hydro-alcoolique.

La dispersion colloïdale obtenue est stable et permet en outre d'obtenir un film de sulfure(s) métallique(s) cristallin(s) compacte à gros grains conformément au but de la présente invention après dépôt et double recuit d'une couche de nanoparticules de sulfure(s) de Cu, Zn et Sn sur un substrat.

De préférence encore, dans le procédé de préparation de la dispersion colloïdale:

- à l'étape a), on réalise une dite première solution aqueuse de NaSH, et

- à l'étape b), on réalise une dite deuxième solution contenant $CuCl_2$, $ZnCl_2$ et $SnCl_4$ dans de l'acétonitrile en mélange avec de l'eau, de préférence dans un rapport volumique acétonitrile/eau d'au moins 50/50, ou de préférence encore de l'acétonitrile pur, et

- à l'étape c), on obtient des nanoparticules de sulfure(s) de Cu, Zn et Sn, de préférence de composé CZTS de taille de 3 à 20 nm.

Plus particulièrement encore, à l'étape 1), on pulvérise une dite dispersion hydro-alcoolique colloïdale, à laquelle on fait subir un traitement de séparation en fonction de la taille par filtration ou de préférence centrifugation, ou un traitement de lyse physique ou mécanique des agglomérats de nanoparticules primaires, pour enlever ou respectivement casser les agglomérats de tailles d'agglomérat supérieure à 10 $\mu$m, de préférence la pulvérisation se faisant avec un gaz porteur constitué d'un gaz sans oxygène, de préférence un gaz neutre, de préférence encore de l'azote, à pression atmosphérique et à une température de substrat porté à au moins 100°C, pour former sur un dit substrat, une couche d'épaisseur de 1 à 15 $\mu$m de préférence d'environ 1 à 10 $\mu$m avant recuit.

Avantageusement, ledit substrat est un substrat destiné à être recouvert d'une couche d'absorption de semi-conducteur de type p dans un dispositif photovoltaïque solide.

Plus particulièrement, ledit substrat est constitué d'une couche de verre ou d'acier recouvert d'une couche dite de contact arrière constituée d'une couche de molybdène, utile dans un dispositif photovoltaïque solide de type substrat.

Dans un dispositif photovoltaïque solide dit de type substrat, les couches ci-dessus sont complétées par :

- une grille métallique appliquée contre ladite couche de contact avant, constituant ainsi la face avant (côté soleil) du dispositif, et
- une couche de verre ou acier appliquée contre ladite couche de contact arrière.

D'autres caractéristiques qui avantagent la présente invention apparaîtront à la lumière des exemples détaillés de réalisation qui vont suivre en référence aux figures suivantes.

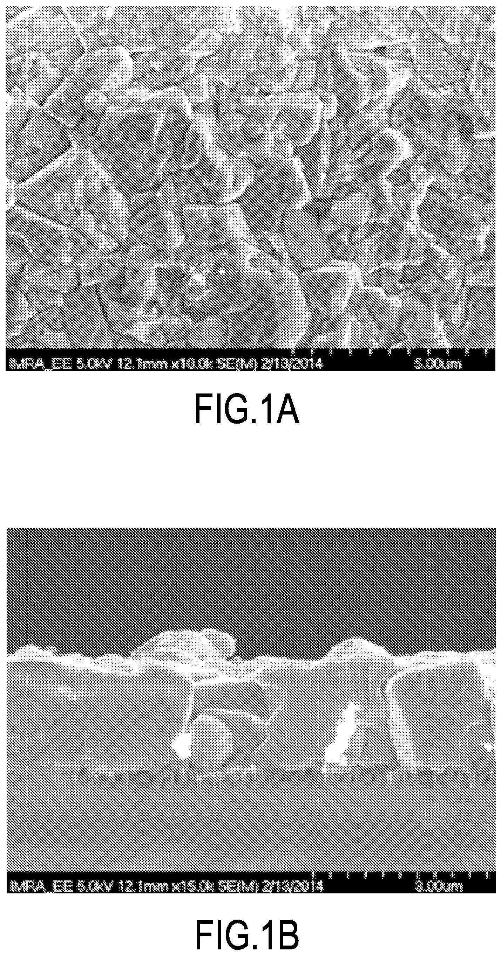

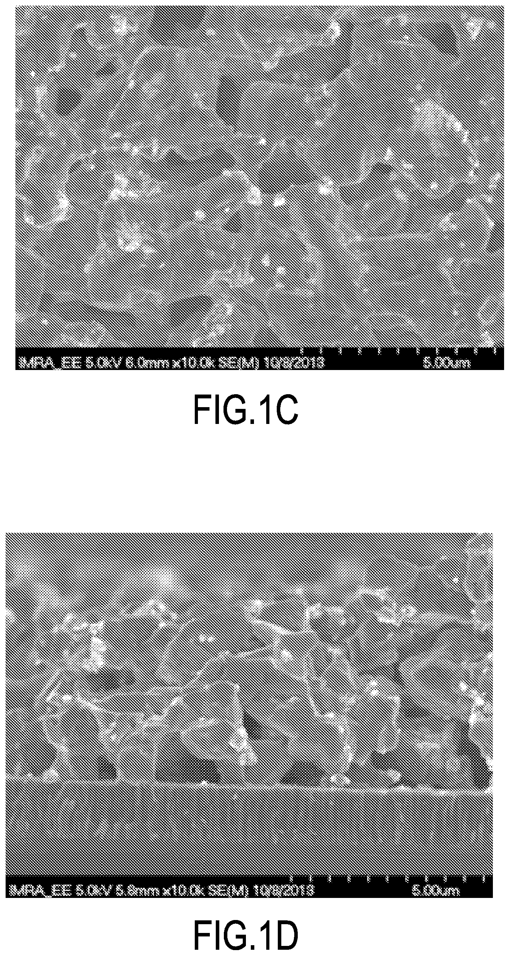

- Les figures 1A à 1D montre des images MEB des couches CZTSSe en vue par-dessus et en coupe : (a) compacte et à gros grains comme celle obtenue dans l'Exemple 1 selon l'invention, en vue par-dessus (fig.1A) et en vue en coupe (fig.1B); (b) poreuse comme dans l'exemple comparatif 4, en vue par-dessus (fig.1C) et en vue en coupe (fig.1D).

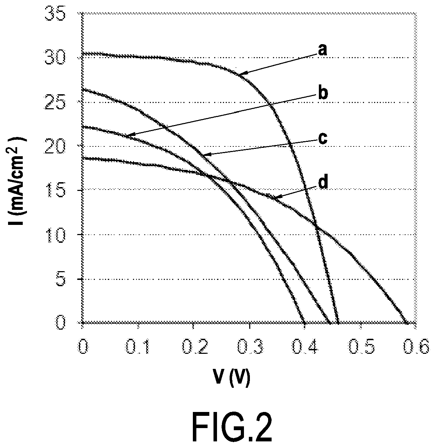

- La figure 2 représente des courbe courant-tension (I-V) des dispositifs photovoltaïques CZTSSe : (a) fait avec une couche CZTSSe selon le procédé de l'invention, selon les Exemples 1 et 2, (b) fait avec une couche CZTSSe selon l'Exemple comparatif 3 ; (c) fait avec une couche CZTSSe selon l'Exemple comparatif 4 ; (d) fait avec une couche CZTS sans Se selon l'Exemple comparatif 5.

La morphologie des couches CZTSSe (épaisseur, taux de recouvrement, porosité, taille de grains) peut être vérifiée par Microscopie Électronique à Balayage (MEB), éventuellement aussi par microscopie électronique à transmission (MET), dans différents zones de la couche, en vues par-dessus et en vues en coupe.

Les phases cristallines présentes dans les couches CZTSSe peuvent être analysées par Diffraction des Rayons X (DRX), typiquement à angle rasant de 1 à 3 degrés.

La composition élémentaire moyenne des couches peut être analysée par spectroscopie de rayons X à dispersion d'énergie (en anglais « Energy Dispersive X-ray spectroscopy », EDX ou EDS), couplée à un appareil MEB, sur des surfaces de dizaines ou centaines de micromètres de côté. L'homogénéité de la composition élémentaire peut être évaluée en plus par cartographie EDX en vues par-dessus.

La performance photovoltaïque des dispositifs photovoltaïques est mesurée à partir des courbes courant-tension (I-V) sous irradiation d'un simulateur solaire à la puissance standard de 1000 W/m$^2$. De ces courbes on calcule le rendement de conversion de la radiation incidente en puissance électrique au point de puissance maximum, et d'autres paramètres de performance tel que le photo-courant à court-circuit et la tension à circuit ouvert.

Différents couches et dispositifs ont été fabriqués avec des différentes approches suivantes :

Une première approche a consisté à introduire le Se dans le précurseurs de sels métalliques utilisés pour la préparation de suspensions de nanoparticules, comme proposé dans certaines publications. On a fabriqué des couches CZTSSe en utilisant des suspensions de nanoparticules CZTSSe synthétisées avec un précurseur à base de NaHSe ou d'un mélange de précurseurs de NaHS et NaHSe, de façon similaire à celui fabriqué avec NaHS selon l'invention et dans WO 2014/016489, et en utilisant plusieurs ratios. Le dépôt des couches a été fait par pulvérisation, selon la même technique que pour les couches CZTS décrites dans WO 2014/016489, la procédure étant modifiée en ce que l'on a changé la buse en verre par une buse en acier, et la méthode à impulsions par un balayage continu. Les couches ont été recuites de différents façons et suivant différents conditions (de température et temps) :

- couche 1-a : Une seule étape de recuit dans une atmosphère inerte (N$_2$),

- couche 1-d : une seule étape de recuit dans atmosphère argon avec des vapeurs de Se (four tubulaire avec ajout de Se solide pour créer des vapeurs lors de la montée en température),

- couche 1-b et 1-c : deux étapes de recuit (une première dans le N$_2$, la deuxième dans l'argon avec des vapeurs de Se (couche 1-b) ou dans l'argon avec H$_2$S (couche 1-c). Les couches étaient compactes et à gros grains. La meilleure performance des dispositifs photovoltaïques fabriqués avec ces couches a été de ~4% (couche 1-b).

Une deuxième approche a consisté à déposer la couche de suspension de nanoparticules CZTS obtenues à partir des précurseurs sans Se et à introduire le Se dans l'étape de recuit, comme proposé dans certaines publications. On a fabriqué des couches CZTSSe en utilisant une suspension de nanoparticules CZTS, comme selon l'invention, suivi d'un seul recuit dans une atmosphère argon avec des vapeurs de Se et différents conditions de température et durée (couche 2-a : 570°C, couche 2-b : 600°C). Les couches recuites n'étaient pas compactes, mais avec une porosité d'environ 50% ; pour certaines conditions les grains étaient plus petits que 700nm. La meilleure performance des dispositifs photovoltaïques fabriqués avec ces couches a été de ~4,5% (couche 2-a).

Une troisième approche a consisté à déposer la couche de suspension de nanoparticules CZTS obtenues à partir des précurseurs sans Se et à introduire le Se avec un recuit particulier à deux étapes, en sachant que des procédés similaires proposés dans certaines publications, mais en utilisant d'autres précurseurs, ont abouti à des couches avec une morphologie pas approprié (taille de grains en dessous de ~1$\mu$m). On a fabriqué des couches CZTSSe en utilisant une suspension de nanoparticules CZTS, suivi de deux étapes de recuit (une première dans le $N_2$, la deuxième dans une atmosphère argon avec des vapeurs de Se (couche 3-a), éventuellement aussi avec présence des vapeurs d'un composé de Sn en plus de Se (couche 3-b) et différents conditions (température, durée, masse de Se). Les couches étaient compactes et à gros grains, contrairement à celles obtenues dans quelques publications utilisant des recuits à deux étapes (voir ci-dessus). La performance des dispositifs photovoltaïques fabriqués avec ces couches a fourni un rendement photovoltaïque supérieur d'au moins 7%, voire supérieur à 8%, avec des photo-courants d'au moins 25mA/cm$^2$ voire dépassant 30mA/cm$^2$.

Le Tableau 1 résume les résultats des analyses des couches CZTSSe sur substrat Mo partant de différent colloïdes (avec ou sans Se) et différents types de recuits.

Le Tableau 2 résume les performances des meilleurs dispositifs photovoltaïques faits avec ces couches CZTSSe sur Mo.

Dans les Tableaux 1 et 2 ci-après, les couches recuites obtenues selon la première approche sont les couches 1-a à 1-d, celles selon la deuxième approche sont les couches 2-a et 2-b, et celles selon l'invention et troisième approche sont les couches 3-a et 3-b.

TABLEAU 1 : Analyse des couches CZTSSe sur substrat Mo en fonction du colloïde précurseur et du type de recuit

| Dans le tableau 1, « Trous » =: plus de 10 trous de plus de 10 microns par cm$^2$. | | | | | |
|---|---|---|---|---|---|
| Couches recuites | Suspension colloïdale | 1ère étape de recuit | 2ème étape de recuit | Phases cristallines secondaires autres que $Zn(S_xSe_{1-x})$ | Morphologie |
| 1-a | CZT-Se | $N_2$ 540-570°C | - | $Sn(S_xSe_{1-x})$ | Dense Grains ~1$\mu$m |
| 1-b | CZT-S-Se | $N_2$ à 530-560°C | Se /Ar 570°C | $Sn(S_xSe_{1-x})$ | Dense Trous Grains ~1$\mu$m |
| 1-c | CZT-S-Se | $N_2$ 560°C | $H_2S$ /Ar 525°C | - | Dense Grains dégradés |
| 1-d | CZT-S-Se | Se /Ar 570°C | - | - | 20-50% de porosité Grains <700nm |
| 2-a | CZT-S | Se /Ar 570°C | - | - | 50% de porosité Grains <500nm |
| 2-b | CZT-S | Se /Ar 600°C | - | phase secondaire inconnue | 50% de porosité Grains ~1$\mu$m |
| 3-a | CZT-S | $N_2$ 525°C | Se /Ar 570°C | - | Dense Grains ~1$\mu$m |
| 3-b | CZT-S | $N_2$ 525°C | Se+SnS /Ar 550°C | - | Dense Grains ~1$\mu$m |

TABLEAU 2 : Performances des meilleurs dispositifs photovoltaïques faits avec des couches CZTSSe sur Mo fabriquées avec différent procédés, et mesurés à une irradiance de $1000W/m^2$ à 25°C. Un comparatif avec une couche CZTS sans Se est rajouté.

| Couches recuites | Colloïde | 1ère étape de recuit | 2ème étape de recuit | Rendement [%] | Photo-courant [mA/cm²] | Tension à circuit ouvert [V] |
|---|---|---|---|---|---|---|
| 1-a | CZT-Se | $N_2$ | - | <0,5% | | |
| 1-b | CZT-S-Se | $N_2$ | Se | ~4% | ~24mA/cm² | ~0,42V |
| 1-c | CZT-S-Se | $N_2$ | $H_2S$ | - | | |
| 1-d | CZT-S-Se | Se | - | ~3% | <26mA/cm² | < 0,40V |
| 2-a | CZT-S | Se | - | ~4% | ~25mA/cm² | ~0,46V |
| 2-b | CZT-S | Se | - | ~4,5% | ~28mA/cm² | ~0,45V |
| 3-a | CZT-S | $N_2$ | Se | ~7% | ~29 mA/cm² | ~0,44V |
| 3-b (exemples 1 et 2) | CZT-S | $N_2$ | Se + Sn | 8,3% | 30,5 mA/cm² | 0,46V |
| 4 (sans Se, exemple 5) | CZT-S | $N_2$ | $H_2S$ | ~5% | <20mA/cm² | ~0,60V |

Dans l'Exemple 1, on décrit la fabrication d'une couche mince CZTSSe suivant le procédé de cette invention qui utilise une dispersion colloïdale des particules CZTS (c'est-à-dire, pas de Se avant recuit) et un recuit à deux étapes, une première en atmosphère neutre, et une deuxième en atmosphère contentant des vapeurs de Se.

Dans l'Exemple 2, on décrit la fabrication d'un dispositif photovoltaïque fait avec la couche mince CZTSSe de l'Exemple 1.

Dans l'Exemple comparatif 3, on décrit la fabrication d'une couche mince CZTSSe (et du dispositif photovoltaïque correspondant) avec un procédé qui utilise une dispersion colloïdale des particules CZTSSe, c'est-à-dire, incorporant du Se dans le colloïde de départ.

Dans l'Exemple comparatif 4, on décrit la fabrication d'une couche mince CZTSSe (et du dispositif photovoltaïque correspondant) qui utilise une dispersion colloïdale des particules CZTS (c'est-à-dire, pas de Se avant recuit) et un recuit à une étape dans une atmosphère contentant des vapeurs de Se, comme celui utilisé dans la plupart de fabrications des couches CZTSSe de l'état de l'art.

Dans l'Exemple comparatif 5, on décrit la fabrication d'une couche mince CZTS sans Se (et du dispositif photovoltaïque correspondant) qui utilise la même dispersion colloïdale des particules CZTS de l'Exemple 1 et un recuit où il n'intervient pas le Se.

**Exemple 1.** Fabrication d'une couche mince de CZTSSe en utilisant une dispersion colloïdale de CZTS (sans Se) et recuite avec un procédé de recuit à deux étapes, une première en atmosphère neutre, et une deuxième en atmosphère contenant de vapeurs de Se.

A) Préparation d'un colloïde de CZTS

Un colloïde de nanoparticules de Cu-Zn-Sn-S a été fabriqué en faisant réagir un mélange de sels métalliques de CuCl, $ZnCl_2$ et $SnCl_4.5H_2O$ dans l'eau/acétonitrile avec une solution aqueuse de NaSH, à température ambiante et sous atmosphère neutre d'azote, selon la réaction globale :

$$2CuCl + ZnCl_2 + SnCl_4 + 4NaSH \Leftrightarrow Cu_2ZnSnS_4 + 4NaCl + 4HCl$$

Ce système réactif est adapté dans le sens que les sous-produits de réaction, par exemple NaCl ou HCl, sont solubles dans l'eau tandis que les nanoparticules sont solides, et dispersées sous forme de colloïde.

On a préparé une solution aqueuse de 0,12 M de NaSH dans l'eau déionisée. On a préparé une solution des chlorures métalliques de cuivre, zinc et étain mentionnée ci-dessus dans l'acétonitrile en boîte à gants d'azote, à une concentration de ~0,5M en Cu, ~0,25M en Zn et ~0,25M en Sn (typiquement 469 mg de CuCl, 415mg de $ZnCl_2$ et 893 mg de $SnCl_4.5H_2O$ dans 10ml d'acétonitrile). On a pris 1 volume de la solution de chlorures de métaux, on a rajouté 4 volumes d'acétonitrile et 5 volumes d'eau. A cette solution on a rajouté 10 volumes de la solution de NaHS, donnant rapidement une dispersion colloïdale. Le colloïde ainsi obtenu est lavé dans l'eau et l'éthanol par des étapes successives de centrifugation, retrait de surnageant et ré-dispersion. Le précipité après la dernière centrifugation est ré-dispersé (et concentré par rapport au volume initial) par addition de 5 volumes d'éthanol.

Les particules du colloïde rincé ont été analysées par microscopie électronique à transmission MET, qui a montré des nanoparticules de forme arrondie, de taille moyenne de l'ordre de 10 nm typiquement.

Quelques gouttes du colloïde ont été déposées sur un substrat de verre dans une boîte à gants en azote, laissées sécher, puis le dépôt sec du colloïde a été recuit dans l'azote pendant une heure à 525°C. La caractérisation DRX a donné les pics typiques du $Cu_2ZnSnS_4$ ; l'analyse élémentaire par EDX du dépôt recuit a donné des pourcentages Cu:Zn:Sn moyens (statistique sur plusieurs lots) de 48:29:23.

B) Préparation d'un film de suspension de particules CZTS sur substrat de verre recouvert de molybdène.

Le dépôt du film de CZTS a été fait par pulvérisation dans une boîte à gants remplie d'azote. On a préparé une dispersion colloïdale en mélangeant 2 volumes de la dispersion colloïdale alcoolique obtenue en 1A avec 18 volumes d'eau, et on l'a soumis aux ultrasons afin de casser les possibles agglomérats des particules, plus particulièrement ceux de plus de ~10μm. La dispersion hydro-alcoolique résultante a été pulvérisée sur des substrats commerciaux de verre sodo-calcique avec une couche de Mo, de dimensions 2,5x2,5 cm. Des substrats commerciaux de verre sodo-calcique avec une couche de Mo, de dimensions 2,5x2,5 cm, ont été placés sur une plaque chauffante une température de 300°C.

La buse de pulvérisation utilisée était une buse commerciale en acier inoxydable, alimentée en azote comme gaz porteur de pulvérisation, en flux continu de 9 L/min. L'injection de la solution colloïdale dans la buse a été faite en continu à l'aide d'une pompe péristaltique. La pulvérisation a été faite en balayant la surface des substrats à l'aide d'un robot X-Y, pendant 10 minutes. On a obtenu ainsi une couche colorée uniforme à la vue.

C) Préparation d'un film de CZTSSe cristallisé par recuit du film obtenu dans 1B.

Le film obtenu dans 1B a été soumis à une première étape de recuit sous atmosphère $N_2$ sur une plaque chauffante placée dans une boîte à gants remplie à l'azote sec, avec un plateau à 525°C pendant 15 min (avec une monté dans 50 minutes et un refroidissement naturel à température ambiante aux alentours de 25-30°C), tel que décrit dans notre publication (Larramona et al. RSC Advances 4 (2014) 14655). Ensuite, on a réalisé une deuxième étape de recuit dans un four tubulaire, sous flux d'argon, en plaçant le substrat dans une boîte en graphite dans laquelle on a aussi déposé :

- couche 3-a des Tableaux 1 et 2 : 40 mg de sélénium, avec un plateau de chauffe à 570°C pendant 30 min (avec une monté dans 50 minutes et un refroidissement d'environ 1 heure à température ambiante aux alentours de 25-30°C), ou

- couche 3-b des Tableaux 1 et 2: 80 mg de sélénium et 5 mg de SnS, avec un plateau de chauffe à 550°C pendant 30 min (avec une monté dans 20 minutes et un refroidissement d'environ 1 heure à température ambiante aux alentours de 25-30°C).

La génération des vapeurs de Se est réalisée par introduction d'une masse de Se solide près des couches à recuire (optionnellement, les couches et le Se étant introduits dans une boîte en graphite pour confiner les vapeurs et pour monter en température plus rapidement par l'effet de corps noir), ou par chauffage du Se solide en amont d'un four tubulaire (ou dans une chambre ou dans un four auxiliaire chauffée et connecté au four principale), les vapeurs de Se étant diluées, mélangées et emmenées par le gaz porteur (par exemple Ar ou $N_2$) sur les couches situées en aval. La masse de Se introduite est calculée pour qu'il soit en excès par rapport à la quantité de couche CZTS à séléniser et aussi pour que la pression partielle des vapeurs de Se soit dans l'intervalle de 0,02 et 0,2 bar dans l'atmosphère de l'enceinte de recuit (gaz neutre plus vapeurs Se) au long du recuit.

Après ce recuit la couche était dense et compacte tel que défini ci-dessus et la taille de grains de l'ordre de 1 μm, tel qu'observé par une analyse MEB en vue dessus. Une vue de section du film obtenu après recuit a montré des épaisseurs du film CZTS aux alentours de 2 à 3 μm. Le nombre de trous supérieurs à 10 μm présents dans les films était inférieur à 5 par cm$^2$, tel qu'observé avec un microscope optique.

L'analyse DRX a montré un diffractogramme caractéristique du composé $Cu_2SnZn(S_{1-p}Se_p)_4$, avec une petite présence de ZnS. L'analyse EDX a montré un taux de Se « Se% » de ~55% dans les deux couches. La cartographie EDX a montré une distribution homogène des cinq éléments, avec seulement des petites zones plus riches en Zn par rapport à la stoechiométrie Cu:Zn:Sn 50:25:25, liés à la présence de la phase secondaire ZnS en petite proportion. Un autre petit pic DRX était aussi présent, mais dans une quantité extrêmement faible, l'air de pic étant beaucoup plus petit que 1/50 de celui du pic principal du $Cu_2SnZn(S_{1-p}Se_p)_4$, et la phase correspondante n'a pas pu être encore identifiée.

**Exemple 2.** Fabrication d'un dispositif photovoltaïque du type couche mince réalisé avec une couche CZTSSe fabriquée comme dans l'Exemple 1.

Sur les couches CZTSSe de l'Exemple 1 on a déposé successivement une couche tampon de CdS, une couche transparente de ZnO, et une couche transparente conductrice d'oxyde d'indium dopé Sn (ITO, en anglais) comme décrit dans Larramona et al. RSC Advances 4 (2014) 14655. On a déposé la couche tampon de CdS de 50 nm approximativement, par dépôt chimique (Chemical Bath Déposition, CBD, en anglais), suivant la procédure usuel de l'état de l'art. Sur cette couche on a déposé successivement la couche transparente de ZnO de 50 nm approximativement, suivie de la couche transparente conductrice d'oxyde d'indium dopé Sn (ITO, en anglais) de 250 nm approximativement, par pulvérisation cathodique magnétron en utilisant un appareil commercial.

Ensuite, chaque substrat a été divisé en 16 cellules électriquement isolées, des dimensions 0,5x0,5 cm. Un petit point d'argent a été déposé (par séchage d'une laque chargée en argent) sur la couche transparente de contact avant afin de collecter le courant et placer un des contacts pour mesurer la performance photovoltaïque. Le deuxième contact a été fait directement sur la Mo au bord du substrat.

Le rendement photovoltaïque a été mesuré avec un test standard en réalisant des courbes courant-tension sous simulateur solaire sous une irradiance de 1000 W/m$^2$ correspondant à la norme AM1.5G et avec le dispositif à 25°C, tel que décrit dans Larramona et al. RSC Advances 4 (2014) 14655 et FR2899385.

Le rendement photovoltaïque a été calculé à partir des caractéristiques électriques courant-tension du dispositif photovoltaïque mesurées sous irradiation lumineuse. Le rendement de conversion est le pourcentage de la puissance électrique délivrée par le dispositif au point de puissance maximum, par rapport à la puissance de la radiation incidente : $\eta$= (puissance électrique au point de puissance maximum)/(puissance de la radiation incidente). Cette efficacité photovoltaïque a été mesurée avec un banc de test électrique et qui utilise un simulateur solaire délivrant une irradiance de 1000 W/m$^2$ correspondant à la norme AM1.5G. Le banc de mesure a été calibré selon la procédure standard sur la base du photo-courant connu de cellules de référence, telles que fournies par différents instituts officiels reconnus.

La meilleure performance a été de 8,3%, avec un photo-courant à court-circuit de 30,5 mA/cm$^2$ et une tension à circuit ouvert de 0,46 V (couche 3-b des Tableaux 1 et 2).

**Exemple comparatif 3.** Fabrication d'une couche mince de CZTSSe en utilisant une dispersion colloïdale de CZTSSe et recuite, et d'un dispositif photovoltaïque du type couche mince réalisé avec cette couche.

On a préparé un colloïde des nanoparticules de CZTSSe de façon similaire au colloïde CZTS de l'Exemple 1A, mais un utilisant un mélange de précurseurs NaHSe et NaHS avec un ratio molaire de 1 :4. Ensuite, on a préparé une dispersion colloïdale en mélangeant 2 volumes de la dispersion colloïdale alcoolique obtenue précédemment avec 18 volumes d'eau, et on l'a pulvérisé sur des substrats commerciaux de verre sodo-calcique avec une couche de Mo comme dans l'Exemple 1B. Ensuite, on a soumis le film obtenu à une première étape de recuit sous atmosphère N$_2$ sur une plaque chauffante placée dans une boîte à gants remplie à l'azote sec, avec un plateau à une température choisie dans l'intervalle de 530°C à 570°C (selon les différents essais) pendant 15 min, et refroidissement naturel, suivi d'une deuxième étape de recuit dans un four tubulaire, sous flux d'argon, dans une boîte en graphite dans laquelle on a placé aussi 40 mg de sélénium, avec un plateau à une température choisie dans l'intervalle de 530°C à 570°C (selon les différents essais) pendant 30 min et refroidissement en une 1 heure.

Les couches étaient similaires en morphologie, phase cristalline et homogénéité de composition à la couche de l'Exemple 1.

Avec ces couches on a fabriqué des dispositifs photovoltaïques en suivant la procédure de l'Exemple 2. La meilleure performance a été de 4%, avec un photo-courant à court-circuit de 24mA/cm$^2$ et une tension à circuit ouvert de 0,42 V (couche 1-b des Tableaux 1 et 2, avec une première étape de recuit dans le N$_2$ à 550°C et une deuxième étape de recuit dans le Se à 570°C).

Dans un essai comparatif, on a effectué des couches recuites préparée à partir de particules de CZTSSe comme ci-dessus mais avec du H$_2$S pour le deuxième recuit à la place de Se (couche recuite 1-c des Tableaux 1 et 2).

Dans un autre essai comparatif, on a effectué des couches recuites préparée à partir de particules de CZTSSe comme ci-dessus mais avec des vapeurs de Se dans l'atmosphère du premier recuit et sans deuxième recuit.

Dans un autre essai comparatif, on a omis de mettre du S (que du Se) dans les particules de la dispersion initiale et on n'a pas fait de deuxième recuit (couche recuite 1-a des Tableaux 1 et 2).

Tous ces autres essais ont donné des performances inférieures à celle de la dite couche 1-b des Tableaux 1 et 2, voire des performances très faibles.

**Exemple comparatif 4.** Fabrication d'une couche mince de CZTSSe en utilisant une dispersion colloïdale de CZTS (sans Se) et recuite avec une seule étape de recuit faite dans une atmosphère contenant des vapeurs de Se, et fabrication d'un dispositif photovoltaïque du type couche mince réalisé avec cette couche.

On a préparé un colloïde des nanoparticules de CZTS comme dans l'Exemple 1A. Ensuite, on a préparé une dispersion colloïdale en mélangeant 2 volumes de la dispersion colloïdale alcoolique obtenue précédemment avec 18 volumes d'eau, et on l'a pulvérisé sur des substrats commerciaux de verre sodo-calcique avec une couche de Mo comme dans l'Exemple 1B. Ensuite, on a soumis le film obtenu à une seule étape de recuit dans un four tubulaire, sous flux d'argon, dans une boîte en graphite dans laquelle on a déposé aussi 40 mg de sélénium, avec un plateau à 570°C (couche 2-a du Tableau 1) ou 600°C (couche 2-b du Tableau 1) pendant 30 min et refroidissement en une 1 heure.

Contrairement à la couche de l'Exemple 1, ces couches n'étaient pas compactes, mais poreuses. La taille de grains de la couche 2-b était de l'ordre de 1 $\mu$m et la taille de pores était jusqu'à 1 $\mu$m, celles de la couche 2-a étant plus petits, de moins de 500nm.

Avec ces couches on a fabriqué des dispositifs photovoltaïques en suivant la procédure de l'Exemple 2. La meilleure performance a été de 4,5%, avec un photo-courant à court-circuit de 28 mA/cm$^2$ et une tension à circuit ouvert de 0,45 V (couche recuite 2-b des Tableaux 1 et 2).

**Exemple comparatif 5.** Fabrication d'une couche mince de CZTS en utilisant une dispersion colloïdale de CZTS et recuite avec deux étapes de recuit, une première en atmosphère neutre, et une deuxième en atmosphère contenant du H$_2$S.

On a préparé un colloïde des nanoparticules de CZTS comme dans l'Exemple 1A. Ensuite, on a préparé une dispersion colloïdale en mélangeant 2 volumes de la dispersion colloïdale alcoolique obtenue précédemment avec 18 volumes d'eau, et on l'a pulvérisé sur des substrats commerciaux de verre sodo-calcique avec une couche de Mo comme dans l'Exemple 1B. Ensuite, on a soumis le film obtenu à une première étape de recuit sous atmosphère N$_2$ sur une plaque chauffante placée dans une boîte à gants remplie à l'azote sec, avec un plateau à 525°C pendant 15 min, et refroidissement naturel. On a réalisé une deuxième étape de recuit sous une atmosphère H$_2$S, dans un four tubulaire, sous flux de H$_2$S à 3% dans l'argon, avec un plateau à 525°C pendant 60 minutes et un refroidissement de 1 heure.

La couche 4 (du Tableau 2) obtenue était dense et la taille de grains de l'ordre de 1 $\mu$m tel que observé par MEB. L'analyse DRX a montré un diffractogramme caractéristique du composé Cu$_2$SnZnS$_4$ (sans Se). La cartographie EDX a trouvé une distribution homogène des quatre éléments, avec seulement des petites zones légèrement plus riches en Zn par rapport à la stoechiométrie Cu:Zn:Sn 50:25:25.

La couche CZTS a été ensuite immergée dans une solution d'acide chlorhydrique, HCl, à 8% en poids pendant 1 à 2 minutes. Puis elle a été rincée avec de l'eau déionisée et séchée sous flux d'azote. Après ce traitement, avec cette couche on a fabriqué des dispositifs photovoltaïques en suivant la procédure de l'Exemple 2. La meilleure performance a été de 5%, avec un photo-courant à court-circuit de 19 mA/cm$^2$ et une tension à circuit ouvert de 0,58 V (couche 4 du Tableau 2).

## Revendications

1. Procédé de fabrication d'une couche mince de matériau absorbeur composé essentiellement de sulfure(s) et séléniure(s) de Cu, Zn et Sn, avec des pourcentages atomiques des trois métaux Cu, Zn et Sn pouvant varier dans l'intervalle de x=40 à 60% pour le Cu et y= 15 à 35% pour le Zn et z= 15 à 35% Sn, avec x+y+z=100%, avec un pourcentage atomique de Se en remplacement du S pouvant varier dans l'intervalle de 5% à 100%, sous forme de composé pentanaire Cu-Zn-Sn-S-Se, ci-après désigné par un composé CZTSSe, à gros grains cristallins de taille moyenne d'au moins 700nm, ladite couche mince d'absorbeur étant déposée sur un (ou des) matériau(x) en couche(s) formant un substrat, dans lequel on réalise les étapes successives suivantes :

   1) on dépose une couche à l'aide d'une dispersion de particules, sous forme de liquide, lesdites particules étant des nanoparticules de sulfure(s) de Cu, Zn et Sn, contenant des nanoparticules de composés quaternaires Cu-Zn-Sn-S contenant un taux de composés quaternaires d'au moins 70 %, le reste étant constitué de nanoparticules binaires M-S ou ternaires M-M'-S, M et M' étant Cu, Zn ou Sn, sur une couche de molybdène (Mo) d'un dit substrat recouvert d'une couche de molybdène (Mo), et

   2) on réalise un traitement thermique de recuit de ladite couche déposée sur ledit substrat, à une température maximale d'au moins 450°C,

   pour obtenir une cristallisation et une croissance des nanoparticules **caractérisé en ce que** :

      - à l'étape 1), on dépose une couche à l'aide d'une dispersion hydro-alcoolique colloïdale de particules, lesdites particules comprenant des nanoparticules primaires de composés quaternaires CZTS de sulfure(s) de Cu, Zn et Sn de tailles inférieures à 100 nm dans laquelle on a éliminé les agglomérats de nanoparticules primaires de taille d'agglomérat supérieure à 5 $\mu$m, déposée à pression atmosphérique, sous forme de liquide par pulvérisation ou par impression, et
      - à l'étape 2), ledit traitement thermique comprend deux étapes de recuit dans des atmosphères différentes suivantes successives pour obtenir des gros grains cristallins de taille moyenne d'au moins 700nm, sur une épaisseur de 1 à 5 $\mu$m, à savoir:
      - une première étape de recuit dans une atmosphère de gaz neutre, et
      - une deuxième étape de recuit dans une atmosphère de gaz neutre contenant des vapeurs de Se.

**2.** Procédé selon la revendication 1, **caractérisé en ce qu'**on réalise la deuxième étape de recuit dans une atmosphère de gaz neutre contenant des vapeurs de Se, et contenant aussi des vapeurs d'un composé de Sn.

**3.** Procédé selon la revendication 1 ou 2, **caractérisé en ce que** dans la deuxième étape de recuit, on vaporise l'élément Se, à partir dudit élément Se solide en excès, et le cas échéant on vaporise aussi un composé de Sn, à partir de dit composé solide en excès.

**4.** Procédé selon l'une des revendications 1 à 3, **caractérisé en ce que** dans la deuxième étape de recuit, on vaporise l'élément Se de manière à atteindre une pression partielle de vapeur de Se de 100 à $3 \cdot 10^4$ Pa, et le cas échéant la pression partielle du composé de Sn est entre 10% et 100% de sa pression de vapeur saturante à la température de recuit pour l'intervalle de températures de 450°C à 600°C.

**5.** Procédé selon l'une des revendications 1 à 4, **caractérisé en ce que** la température maximale pour les deux première et deuxième étapes de recuit est de 450 à 600°C, et la durée de traitement à ladite température maximale est de 10 à 120 minutes.

**6.** Procédé selon l'une des revendications 1 à 5, **caractérisé en ce que** ladite dispersion de particules est une dispersion colloïdale de nanoparticules primaires de tailles de 2 à 50 nm, dans laquelle on a éliminé les agglomérats de nanoparticules primaires de taille d'agglomérat supérieure à 5 $\mu$m, et pouvant contenir un pourcentage atomique d'éléments alcalin ou alcalino-terreux, inférieur à 4% en pourcentage atomique.

**7.** Procédé selon la revendication 6, **caractérisé en ce que**, à l'étape 1), ladite dispersion colloïdale est préparée en réalisant les étapes successives suivantes dans lesquelles :

a) on réalise une première solution aqueuse, alcoolique ou hydro-alcoolique de précurseurs de sulfures consistant dans un (ou des) sel(s) métallique(s) de sulfure(s), autres que des sels de cuivre, zinc et étain, et
b) on réalise une deuxième solution de précurseurs de cuivre, zinc et étain, autres que des sulfures de cuivre, zinc et étain, en solution dans un solvant comprenant de l'acétonitrile pur ou en mélange avec de l'eau et/ou un alcool, et
c) on mélange à pression atmosphérique et température ambiante les 2 dites première et deuxième solutions de précurseurs jusqu'à obtenir une dispersion colloïdale brute, et
d) on sépare la partie solide de ladite dispersion colloïdale de l'étape c), et
e) on rince le précipité solide obtenu à l'étape d) en y versant un solvant aqueux, d'acétonitrile, alcoolique ou hydro-alcoolique pour réformer une dispersion colloïdale, et
f) on sépare à nouveau le précipité solide de ladite dispersion colloïdale de l'étape e), et
g) on élimine les éventuels agglomérats de nanoparticules primaires de tailles d'agglomérat supérieure à 5 $\mu$m, par séparation en fonction de la taille par filtration ou par lyse mécanique.

**8.** Procédé de préparation selon la revendication 7, **caractérisé en ce que** :

- à l'étape a), on réalise une dite première solution aqueuse de NaSH, et
- à l'étape b), on réalise une dite deuxième solution contenant $CuCl_2$, $ZnCl_2$ et $SnCl_4$ dans de l'acétonitrile en mélange avec de l'eau et
- à l'étape c), on obtient des nanoparticules de sulfure(s) de Cu, Zn et Sn.

**9.** Procédé selon l'une des revendications 1 à 8, **caractérisé en ce que** à l'étape 1), on pulvérise une dite dispersion aqueuse colloïdale, à laquelle on fait subir un traitement de séparation en fonction de la taille par filtration ou un traitement de lyse mécanique ou physique des agglomérats de nanoparticules primaires pour enlever ou respectivement casser les agglomérats de tailles supérieure à 5 $\mu$m, la pulvérisation se faisant avec un gaz porteur constitué d'un gaz sans oxygène, à pression atmosphérique et à une température de substrat porté à au moins 100°C, pour former sur un dit substrat, une couche d'épaisseur de 1 à 15 $\mu$m, avant recuit.

**10.** Procédé selon l'une des revendications 1 à 9, **caractérisé en ce que** ledit substrat est un substrat destiné à être recouvert d'une couche d'absorption de semi-conducteur de type p dans un dispositif photovoltaïque solide.

**Patentansprüche**

1. Verfahren zur Herstellung einer dünnen Schicht aus Absorbermaterial, das im Wesentlichen aus Sulfid(en) und Selenid(en) von Cu, Zn und Sn besteht, mit Atomprozentsätzen der drei Metalle Cu, Zn und Sn, die in dem Intervall von x = 40 bis 60 % für das Cu und y = 15 bis 35 % für das Zn und z = 15 bis 35 % Sn variieren können, wobei x+y+z = 100 % gilt, mit einem Atomprozentsatz von Se als Ersatz des S, der in dem Intervall von 5 % bis 100 % variieren kann,
in Form einer pentanären Verbindung Cu-Zn-Sn-S-Se, die im Folgenden als eine Verbindung CZTSSe bezeichnet wird, mit großen Kristallkörnern einer mittleren Größe von zumindest 700 nm, wobei die dünne Schicht aus Absorbermaterial auf einem (oder mehreren) Material(ien) in (einer) Schicht(en) abgeschieden wird/werden, das/die ein Substrat bildet/bilden, wobei der Reihe nach die folgenden Schritte durchgeführt werden:

    1) Abscheiden einer Schicht mittels einer Partikeldispersion in Form einer Flüssigkeit, wobei die Partikel Nanopartikel von Sulfid(en) von Cu, Zn und Sn sind, welche Nanopartikel von quaternären Cu-Zn-Sn-S-Verbindungen enthalten, welche einen Anteil von quaternären Verbindungen von zumindest 70 % enthalten, wobei der Rest aus binären M-S- oder ternären M-M'-S-Nanopartikeln besteht, M und M' Cu, Zn oder Sn sind, auf einer Schicht aus Molybdän (Mo) eines solchen Substrats, das von einer Schicht aus Molybdän (Mo) bedeckt ist, und
    2) Durchführen einer Wärmetemperbehandlung der auf dem Substrat abgeschiedenen Schicht bei einer maximalen Temperatur von zumindest 450 °C,

    um eine Kristallisation und ein Wachstum der Nanopartikel zu erhalten, **dadurch gekennzeichnet, dass**:

    - in Schritt 1) eine Schicht mittels einer kolloidalen hydro-alkoholischen Partikeldispersion abgeschieden wird, wobei die Partikel primäre Nanopartikel aus quaternären CZTS-Verbindungen von Sulfid(en) von Cu, Zn und Sn mit Größen von weniger als 100 nm umfassen, wobei die Agglomerate von primären Nanopartikeln mit einer Agglomeratgröße von mehr als 5 $\mu$m beseitigt wurden, wobei die Schicht bei atmosphärischem Druck in Form einer Flüssigkeit durch Sprühen oder durch Drucken abgeschieden wird, und
    - in Schritt 2) die Wärmebehandlung zwei Temperschritte in der Reihe nach aufeinanderfolgenden unterschiedlichen Atmosphären umfasst, um große Kristallkörner einer mittleren Größe von mindestens 700 nm auf einer Dicke von 1 bis 5 $\mu$m zu erhalten, und zwar:
    - einen ersten Temperschritt in einer Atmosphäre aus Neutralgas, und
    - einen zweiten Temperschritt in einer Atmosphäre aus Neutralgas, die Se-Dämpfe enthält.

2. Verfahren nach Anspruch 1, **dadurch gekennzeichnet, dass** der zweite Temperschritt in einer Atmosphäre aus Neutralgas erfolgt, die Se-Dämpfe enthält, und die auch Dämpfe einer Sn-Verbindung enthält.

3. Verfahren nach Anspruch 1 oder 2, **dadurch gekennzeichnet, dass** in dem zweiten Temperschritt das Element Se aus dem Element Se als Feststoff im Überschuss verdampft wird, und gegebenenfalls auch eine Sn-Verbindung aus der Verbindung als Feststoff im Überschuss verdampft wird.

4. Verfahren nach einem der Ansprüche 1 bis 3, **dadurch gekennzeichnet, dass** in dem zweiten Temperschritt das Element Se auf solche Weise verdampft wird, dass ein Partialdampfdruck von Se von 100 bis $3 \cdot 10^4$ Pa erreicht wird, und gegebenenfalls der Partialdruck der Sn-Verbindung zwischen 10 % und 100 % ihres Sättigungsdampfdrucks bei der Temper-Temperatur für das Temperaturintervall von 450 °C bis 600 °C beträgt.

5. Verfahren nach einem der Ansprüche 1 bis 4, **dadurch gekennzeichnet, dass** die maximale Temperatur sowohl für den ersten als auch den zweiten Temperschritt 450 bis 600 °C beträgt, und die Behandlungsdauer bei der maximalen Temperatur 10 bis 120 Minuten beträgt.

6. Verfahren nach einem der Ansprüche 1 bis 5, **dadurch gekennzeichnet, dass** die Partikeldispersion eine kolloidale Dispersion von primären Nanopartikeln mit Größen von 2 bis 50 nm ist, wobei die Agglomerate von primären Nanopartikeln mit einer Agglomeratgröße von mehr als 5 $\mu$m beseitigt wurden, und sie einen Atomprozentsatz von Alkali- oder Alkalierdmetall-Elementen von weniger als 4 % Atomprozentsatz enthalten kann.

7. Verfahren nach Anspruch 6, **dadurch gekennzeichnet, dass** in Schritt 1) die kolloidale Dispersion hergestellt wird, indem der Reihe nach die folgenden Schritte durchgeführt werden:

a) Herstellen einer ersten wässrigen, alkoholischen oder hydro-alkoholischen Lösung von Sulfid-Vorläufern, die aus einem (oder mehreren) Metallsalz(en) von Sulfid(en) bestehen, mit Ausnahme der Salze von Kupfer, Zink und Zinn, und

b) Herstellen einer zweiten Lösung von Vorläufern mit Kupfer, Zink und Zinn, mit Ausnahme der Sulfide von Kupfer, Zink und Zinn, in Lösung in einem Lösungsmittel umfassend reines Acetonitril oder in Mischung mit Wasser und/oder einem Alkohol, und

c) Mischen der 2 Lösungen, also der ersten und der zweiten, von Vorläufern bei atmosphärischem Druck und Umgebungstemperatur, bis eine rohe kolloidale Dispersion erhalten wird, und

d) Abtrennen des festen Teils der kolloidalen Dispersion von Schritt c), und

e) Spülen des in Schritt d) erhaltenen festen Präzipitats, indem es in ein wässriges, alkoholisches oder hydro-alkoholisches Lösungsmittel oder Acetonitril gegeben wird, um erneut eine kolloidale Dispersion zu bilden, und

f) erneutes Abtrennen des festen Präzipitats aus der kolloidalen Dispersion von Schritt e), und

g) Beseitigen eventueller Agglomerate von primären Nanopartikeln mit Agglomeratgrößen von mehr als 5 $\mu$m, durch Trennung in Abhängigkeit von der Größe durch Filtration oder durch mechanische Lyse.

**8.** Herstellungsverfahren nach Anspruch 7, **dadurch gekennzeichnet, dass**:

- in Schritt a) eine erste wässrige Lösung von NaSH hergestellt wird, und
- in Schritt b) eine zweite Lösung hergestellt wird, die $CuCl_2$, $ZnCl_2$ und $SnCl_4$ in Acetonitril in Mischung mit Wasser enthält, und
- in Schritt c) Nanopartikel von Sulfid(en) von Cu, Zn und Sn erhalten werden.

**9.** Verfahren nach einem der Ansprüche 1 bis 8, **dadurch gekennzeichnet, dass** in Schritt 1) eine wässrige kolloidale Dispersion zerstäubt wird, welche einer Behandlung zur Abtrennung von Agglomeraten primärer Nanopartikel in Abhängigkeit von der Größe durch Filtration oder eine mechanische oder physische Lysebehandlung unterzogen wird, um die Agglomerate mit Größen von mehr als 5 $\mu$m zu beseitigen oder aufzubrechen, wobei die Zerstäubung mit einem Trägergas, das aus einem sauerstofffreien Gas besteht, bei atmosphärischem Druck und bei einer Temperatur des mitgeführten Substrats von zumindest 100 °C erfolgt, um auf dem Substrat eine Schicht mit einer Dicke von 1 bis 15 $\mu$m vor der Temperung zu bilden.

**10.** Verfahren nach einem der Ansprüche 1 bis 9, **dadurch gekennzeichnet, dass** das Substrat ein Substrat ist, das dazu bestimmt ist, mit einer Absorberschicht aus einem Halbleiter des p-Typs in einer festen Photovoltaikvorrichtung beschichtet zu werden.

**Claims**

**1.** A method for manufacturing a thin layer of absorbing material consisting substantially of one or more sulfides and selenides of Cu, Zn and Sn, with the atomic percentages of the three materials Cu, Zn and Sn being able to vary in the interval from x=40 to 60% for Cu and y= 15 to 35% for Zn and z= 15 to 35% for Sn, with x+y+z=100%, with an atomic percentage of Se by replacing S being able to vary in the interval from 5% to 100%, in the form of a pentanary compound Cu-Zn-Sn-S-Se, hereinafter designated as a CZTSSe compound, with large crystal grains having an average size of at least 700 nm, said thin layer of absorber being deposited on one or more materials in one or more layers forming a substrate, wherein the following successive steps are performed:

1) a layer is deposited using a dispersion of particles, in liquid form, said particles being nanoparticles of one or more Cu, Zn and Sn sulfides, containing nanoparticles of quaternary compounds Cu-Zn-Sn-S having a content of quaternary compounds of at least 70%, the remainder consisting of binary nanoparticles M-S or ternary nanoparticles M-M'-S, M and M' being Cu, Zn or Sn, on a molybdenum (Mo) layer of a said substrate covered with a layer of molybdenum (Mo), and

2) an annealing heat treatment of said layer deposited on said substrate is performed at a maximum temperature of at least 450°C, in order to obtain crystallisation and growth of the nanoparticles, **characterised in that**:

- in step 1), a layer is deposited using a colloidal hydroalcoholic dispersion of particles, said particles comprising primary nanoparticles of quaternary compounds CZTS of one or more Cu, Zn and Sn sulfides of sizes less than 100 nm, wherein the agglomerates of primary nanoparticles of agglomerate sizes greater than 5 $\mu$m, deposited at atmospheric pressure, in liquid form by spraying or by immersion have been removed, and
- in step 2), said heat treatment comprises two annealing steps in different atmospheres following successively, in order to obtain large crystal grains with average size of at least 700 nm, on a thickness of 1 to 5 $\mu$m, namely:
- a first annealing step in an inert gas atmosphere, and
- a second annealing step in an inert gas atmosphere containing Se vapours.

2.  The method according to claim 1, **characterised in that** the second annealing step is carried out in an inert gas atmosphere containing Se vapours, and also containing vapours of a Sn compound.

3.  The method according to claim 1 or 2, **characterised in that**, in the second annealing step, the element Se is vaporised, from said solid element Se in excess, and, if necessary, a compound of Sn is also vaporised, from said solid compound in excess.

4.  The method according to one of claims 1 to 3, **characterised in that**, in the second annealing step, the element Se is vaporised in such a way as to attain a partial vapour pressure of Se from 100 to $3 \cdot 10^4$ Pa, and if necessary the partial pressure of the compound of Sn is between 10% and 100% of its saturated vapour pressure at the annealing temperature for the temperature interval from 450°C to 600°C.

5.  The method according to one of claims 1 to 4, **characterised in that** the maximum temperature for the two first and second annealing steps is 450 to 600°C, and the processing time at said maximum temperature is 10 to 120 minutes.

6.  The method according to one of claims 1 to 5, **characterised in that** said dispersion of particles is a colloidal dispersion of primary nanoparticles of size 2 to 50 nm, wherein the agglomerates of primary nanoparticles of agglomerate size greater than 5 $\mu$m have been removed, and are able to contain an atomic percentage of alkali and alkaline earth elements of less than 4% in atomic percent.

7.  The method according to claim 6, **characterised in that**, in step 1), said colloidal dispersion is prepared by carrying out the following successive steps, in which:

a) a first aqueous, alcoholic or hydroalcoholic solution is produced from sulfide precursors consisting of one or more metal salts of sulfides other than copper, zinc and tin salts, and
b) a second solution is produced from precursors of copper, zinc and tin, other than the sulfides of copper, zinc and tin, in solution in a solvent comprising acetonitrile that is pure or in a mixture with water and/or an alcohol, and
c) said two first and second solutions of precursors are mixed at atmospheric pressure and ambient temperature until a crude colloidal dispersion is obtained, and
d) the solid part of said colloidal dispersion from step c) is separated, and
e) the solid precipitate obtained in step d) is rinsed by pouring an aqueous, acetonitrile, alcoholic or hydroalcoholic solution in order to reform a colloidal dispersion, and
f) the precipitated solid from said colloidal dispersion from step e) is again separated, and
g) any agglomerates of primary nanoparticles with agglomerate size greater than 5 $\mu$m are removed, by separating according to size by means of filtration or by mechanical lysis.

8.  The method of preparation according to claim 7, **characterised in that**:

- in step a), said first aqueous solution of NaSH is produced, and
- in step b), said second solution containing $CuCl_2$, $ZnCl_2$ and $SnCl_4$ in acetonitrile is produced by mixing with water and
- in step c), nanoparticles of one or more Cu, Zn and Sn sulfides are obtained.

9.  The method according to one of claims 1 to 8, **characterised in that**, in step 1), a said colloidal aqueous dispersion is sprayed, which is made to undergo a separation process according to the size by means of filtration or a mechanical or physical lysis process of agglomerates of primary nanoparticles in order to remove or respectively break up the agglomerates of size greater than 5 $\mu$m, the spraying being carried out with a carrier gas consisting of an oxygen-free gas, at atmospheric pressure and at a substrate temperature brought to at least 100°C, in order to form a layer of thickness 1 to 15 $\mu$m on said substrate, before annealing.

10. The method according to one of claims 1 to 9, **characterised in that** said substrate is a substrate intended to be covered with an absorption layer of p-type semiconductor in a solid photovoltaic device.

FIG.1A

FIG.1B

FIG.1C

FIG.1D

FIG.2

# RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2013172949 A
- WO 2013015745 A
- WO 2014016489 A
- FR 2899385

**Littérature non-brevet citée dans la description**

- **SHIN et al.** *Prog. Photovolt. : Res. Appl.,* 2011, vol. 21, 72
- **WANG et al.** *Adv. Energy Mater.,* 2014
- Thin film solar cells ; fabrication, characterization and applications. Wiley, 2007
- **WANG et al.** *Adv. Energy Mater,* 2014
- **CARTER et al.** *Solar Energy Mater. Solar Cells,* 2014, vol. 123, 189
- **CAO et al.** *J. Am. Chem. Soc.,* 2012, vol. 134, 15644
- **ZHANG et al.** *Appl. Phys. Express,* 2013, vol. 6, 072302
- **KI et al.** *Adv. dans Energy Mater.,* 2011, vol. 1, 732
- **WOO et al.** *Scientific Reports,* 2013, vol. 3, 3069
- **LI et al.** *J. Sol-Gel Sci. Technol.,* 2014, vol. 69, 260
- **LARRAMONA et al.** *RSC Advances,* 2014, vol. 4, 14655